Europäisches Patentamt

European Patent Office

Office européen des brevets

(19)

(11) Veröffentlichungsnummer: **0 293 629**

**A2**

(12) # EUROPÄISCHE PATENTANMELDUNG

(21) Anmeldenummer: 88107286.2

(22) Anmeldetag: 06.05.88

(51) Int. Cl.⁴: **H01L 29/86 , H01L 21/306**

(30) Priorität: 04.06.87 DE 3718683

(43) Veröffentlichungstag der Anmeldung:
**07.12.88 Patentblatt 88/49**

(84) Benannte Vertragsstaaten:
**DE FR GB**

(71) Anmelder: **Licentia Patent-Verwaltungs-GmbH**
**Theodor-Stern-Kai 1**
**D-6000 Frankfurt/Main 70(DE)**

(72) Erfinder: **Behr, Wolfgang**
**Gänsackerweg 9**
**D-7915 Thalfingen(DE)**
Erfinder: **Luy, Johann-Friedrich**
**Schermarweg 3**
**D-7900 Ulm(DE)**
Erfinder: **Strohm, Karl, Dr.**
**Bei der Pilzbuche 40**
**D-7900 Ulm(DE)**

(74) Vertreter: **Amersbach, Werner, Dipl.-Ing. et al**
**Licentia Patent-Verwaltungs-GmbH**
**Theodor-Stern-Kai 1**
**D-6000 Frankfurt 70(DE)**

(54) **Verfahren zum Herstellen eines beidseitig kontaktierbaren Halbleiterbauelements.**

(57) Die Erfindung betrifft ein Verfahren zum Herstellen von beidseitig kontaktierbaren Halbleiterbauelementen, insbesondere Impattdioden. Auf einem Si-Substrat werden die aktiven Si-Schichten der Impattdiode aufgewachsen. Die erste Si-Schicht, die auf das Si-Substrat aufgewachsen ist, besitzt eine hohe Bor- oder Bor/Germanium-Dotierung und wirkt als Ätzstoppschicht beim Entfernen des Si-Substrates. Durch die Bor/Germanium-Dotierung der ersten Si-Schicht, wird die durch die Bor-Dotierung erzeugte mechanische Spannung in der Si-Schicht kompensiert.

EP 0 293 629 A2

## Verfahren zum Herstellen eines beidseitig kontaktierbaren Halbleiterbauelementes

Die Erfindung betrifft ein Verfahren zum Herstellen eines beidseitig kontaktierbaren Halbleiterbauelementes nach dem Oberbegriff des Patentanspruchs 1.

Die Erfindung ist insbesondere für Halbleiterbauelemte anwendbar, die als Impattdioden ausgebildet sind. Derartige Halbleiterbauelemente werden in der Elektrotechnik insbesondere für den GHz-Bereich eingesetzt. Die Herstellung von Doppeldrift-Impattdioden wird in der Veröffentlichung von J.F. Luy et al., IEEE Trans.Electron Dev., Vol. ED-34, Nr. 5, 1987 beschrieben. Auf einem $n^+$-leitenden Silizium(Si)-Substrat werden die aktiven Si-Schichten epitaktisch aufgewachsen. Auf die oberste Halbleiterschicht wird eine Metallisierungsschicht als erste Kontaktschicht abgeschieden. Anschließend wird die untere Seite des $n^+$-leitenden Si-Substrates bis auf 1 $\mu$m planparallel poliert und mit einer verdünnten KOH-Lösung bis auf eine Dicke von weniger als 10 $\mu$m geätzt. Die Dicke des geätzten Si-Substrates wird über die Ätzzeit und durch manuelles Nachätzen festgelegt. Auf die dünne $n^+$-leitende Substratschicht wird eine weitere Metallisierungsschicht aufgebracht, die die zweite Kontaktschicht der Impattdiode bildet. Mit bekannten Fotolack-und Ätzprozessen wird die Impattdiode strukturiert und mit Hilfe der Bondtechnik in eine Wärmesenke eingebaut.

Ein derartiges Herstellungsverfahren hat den Nachteil, daß vor dem Ätzen des Substrates, die Substratfläche planparallel poliert werden muß und das gedünnte Substrat manuell nachgeätzt werden muß, um die gewünschte Substratdicke zu erreichen. Weiterhin sind zusätzliche Meßverfahren notwendig, um zu prüfen, ob das Substrat die gewünschte Dicke aufweist.

Der Erfindung liegt daher die Aufgabe zugrunde ein herstellungstechnisch einfaches und kostengünstiges gattungsgemäßes Verfahren anzugeben, das insbesondere bei industrieller Serienfertigung eine zuverlässige Herstellung des Halbleiterbauelementes ermöglicht.

Der Vorteil der Erfindung besteht darin, daß durch geeignete Dotierung der ersten auf dem Substrat aufgewach senen Halbleiterschicht, eine Ätzstoppschicht erzeugt wird. Beim Ätzen des Substrates stoppt die Ätze selbsttätig an dieser ersten Halbleiterschicht. Das Substrat wird in vorteilhafterweise vollständig entfernt und aufwendige Polier-, Meß- und Ätztechniken zur Erzeugung eines gedünnten Substrates können entfallen.

Die Erfindung wird im folgenden anhand eines Ausführungsbeispieles näher erläutert.

Auf einem n-leitenden Si-Substrat mit einem spezifischen Widerstand von 1 bis 3 $\Omega$ cm wird eine erste Halbleiterschicht aus $p^+$-dotiertem Si epitaktisch aufgewachsen. Die Si-Schicht ist mit Bor dotiert und besitzt eine Ladungsträgerkonzentration von mehr als $7 \cdot 10^{19}$ cm$^{-3}$. Die Schichtdicke der Bor dotierten Si-Schicht beträgt ungefähr 2,0 $\mu$m. Auf diese erste Halbleiterschicht werden weitere Si-Schichten aufgewachsen, derart, daß beispielsweise Impattdioden herstellbar sind.

Auf die erste $p^+$-dotierte Si-Schicht werden z.B.
- eine n-dotierte Si-Schicht und eine $n^+$-dotierte Si-Schicht zur Erzeugung einer $p^+nn^+$-Struktur (Einfachdriftdiode), oder
- eine p-dotierte Si-Schicht, eine n-dotierte Si-Schicht und eine $n^+$-dotierte Si-Schicht zur Erzeugung einer $p^+pnn^+$-Struktur (Doppeldriftdiode), oder
- eine p-dotierte Si-Schicht, eine dünne $n^+$-dotierte Si-Schicht, eine n-dotierte Si-Schicht und $n^+$-dotierte Si-Schicht zur Erzeugung einer $p^+pn^+nn^+$-Struktur (Quasi-Read-Doppeldriftdiode) aufgewachsen.

Die Halbleiterschichten werden mit dem Molekularstrahl-Epitaxie Verfahren und geeigneten Implantations- und Diffusionstechniken hergestellt. Die Schichtdicken der Si-Schichten liegen zwischen 0,2 $\mu$m und 0,35 $\mu$m, nur die dünne $n^+$-dotierte Si-Schicht der Quasi-Read-Doppeldriftdiode besitzt eine Schichtdicke von etwa 0,05 $\mu$m. Für die p-Dotierung der Si-Schichten wird Gallium verwendet mit einer Ladungsträgerkonzentration von ungefähr $2 \cdot 10^{17}$ cm$^{-3}$. Die n- bzw. $n^+$-Dotierung der Si-Schichten erfolgt mit Antimon mit einer Ladungsträgerkonzentration von $2 \cdot 10^{17}$ cm$^{-3}$ bzw. $2 \cdot 10^{19}$ cm$^{-3}$.

Auf die oberste $n^+$-dotierte Si-Schicht der jeweiligen Impattdioden-Struktur wird eine erste Metallisierungsschicht abgeschieden, die z.B. aus einer 0,1 $\mu$m dicken Haftvermittlerschicht aus Titan und einer 0,3 $\mu$m dicken Goldschicht besteht.

Anschließend wird das Si-Substrat mit einer anisotropen Ätze, z.B. verdünnte KOH-Lösung, vollständig entfernt. Dabei wirkt die erste $p^+$-dotierte Si-Schicht der Impattdioden-Struktur als Ätzstoppschicht. Si-Schichten mit einer hohen Bor-Dotierkonzentration von mehr als $7 \cdot 10^{19}$

Ladungsträgern pro cm$^3$ besitzen eine extrem niedrige Ätzrate für gewisse anistrope Ätzen wie z.B. verdünnte KOH-Lösungen. Da Bor einen kleineren Kovalenzradius besitzt als Silizium, hat die hohe Bor-Dotierkonzentration jedoch den Nachteil, daß dadurch in der Bor-dotierten Si-Schicht mechanische Spannungen entstehen. Weiterhin bewirkt die hohe Bor-Dotierung der Si-Schicht in nachteiligerweise Gitterfehler an der Grenzschicht zum Substrat und den nachfolgenden Halbleiterschichten.

Wie in der DE-OS 34 25 063 beschrieben, werden diese Nachteile dadurch vermieden, daß die erste $p^+$-dotierte Si-Schicht mit Bor(B) und Germanium(Ge) dotiert wird.

Germanium besitzt einen größeren Kovalenzradius als Silizium und kann dadurch in der Si-Schicht die durch Bor erzeugten Spannungen kompensieren. Deshalb ist es vorteilhaft, die erste Si-Schicht der Impattdioden-Struktur mit Bor und Germanium zu dotieren. Die Schichtdicke dieser B/Ge-dotierten Si-Schicht beträgt beispielsweise 2 μm und besitzt eine Ladungsträgerkonzentration von etwa $1,3 \cdot 10^{20}$ B/cm³ und $1,4 \cdot 10^{21}$ Ge/cm³.

Die Bor und Germanium-Dotierung der ersten Si-Schicht wirkt sich in vorteilhafterweise auf das nachfolgende Schichtwachstum aus. Die hohe Germanium-Dotierung verhindert das Auftreten von Gitterfehlern und die nachfolgenden Si-Schichten können detektfrei aufwachsen.

Durch die hohe Dotierung von Bor und Germanium besitzt die erste Si-Schicht der Impattdioden-Struktur eine sehr geringe Ätzrate und beim Ätzen des Substrates stoppt die Ätze selbsttätig an der B/Ge-dotierten Si-Schicht. Auf die erste $p^+$-dotierten Si-Schicht wird eine zweite Metallisierungsschicht aus einer 0,1 μm dicken Titan- und einer 0,3 μm dicken Goldschicht aufgebracht. Anschließend wird mit bekannten Fotolack- und Ätzprozessen eine über die erste und zweite Metallisierungsschicht kontaktierbare Impattdiode ausgebildet, die mit Hilfe der Bondtechnik in eine Wärmesenke eingebracht wird.

Die Erfindung ist nicht auf das beschriebene Ausführungsbeispiel beschränkt, sondern sinngemäß für die Herstellung anderer Halbleiterbauelemente geeignet.

**Ansprüche**

1. Verfahren zum Herstellen eines beidseitig kontaktierbaren Halbleiterbauelementes, insbesondere einer Impattdiode, bei welchem auf einem Halbleitersubstrat eine dem Halbleiterbauelement entsprechende Halbleiterschichtenfolge aufgewachsen wird, dadurch gekennzeichnet,
- daß auf dem Halbleitersubstrat eine Halbleiterschichtenfolge aufgewachsen wird, die eine erste $p^+$-dotierte Halbleiterschicht besitzt, und
- daß das Halbleitersubstrat vollständig entfernt wird.

2. Verfahren zum Herstellen eines beidseitig kontaktierbaren Halbleiterbauelementes nach Anspruch 1, dadurch gekennzeichnet, daß das Halbleitersubstrat und die Halbleiterschichtenfolge aus Silizium hergestellt werden.

3. Verfahren zum Herstellen eines beidseitig kontaktierbaren Halbleiterbauelementes nach einem der vorhergehenden Ansprüche, dadurch gekennzeichnet, daß als Dotiermaterial für die erste $p^+$-dotierte Halbleiterschicht Bor verwendet wird.

4. Verfahren zum Herstellen eines beidseitig kontaktierbaren Halbleiterbauelementes nach einem der Ansprüche 1 und 2, dadurch gekennzeichnet, daß als Dotiermaterialien für die erste $p^+$-dotierte Halbleiterschicht Bor und Germanium verwendet werden.

5. Verfahren zum Herstellen eines beidseitig kontaktierbaren Halbleiterbauelementes nach einem der vorhergehenden Ansprüche, dadurch gekennzeichnet, daß zum Entfernen des Halbleitersubstrates eine anisotrope Ätze verwendet wird.

6. Verfahren zum Herstellen eines beidseitig kontaktierbaren Halbleiterbauelementes nach einem der vorhergehenden Ansprüche, dadurch gekennzeichnet, daß das Halbleiterbauelement als Impattdiode ausgebildet wird.